# EUROPÄISCHE PATENTSCHRIFT

(11) **EP 2 272 134 B1**
(45) Veröffentlichungstag und Bekanntmachung des Hinweises auf die Patenterteilung: **23.05.2012**
(21) Anmeldenummer: 09734575.5
(22) Anmeldetag: 16.04.2009
(51) Int. Cl.: H01R 13/52

(54) **STECKVERBINDUNG ZUR KONTAKTIERUNG EINER IN EINEM GEHÄUSE ANGEORDNETEN ELEKTRISCHEN LEITERPLATTE**
PLUG-TYPE CONNECTION FOR MAKING CONTACT WITH AN ELECTRICAL PRINTED CIRCUIT BOARD WHICH IS ARRANGED IN A HOUSING
CONNECTEUR POUR ETABLIR LE CONTACT D' UNE CARTE A CIRCUITS IMPRIMES ELECTRIQUES DISPOSEE DANS UN BOITIER

(30) Priorität: 24.04.2008 DE 102008020668
(43) Veröffentlichungstag der Anmeldung: 12.01.2011
(73) Patentinhaber: Continental Automotive GmbH, 30165 Hannover (DE)
(72) Erfinder: UMFAHRER, Klaus, 70619 Stuttgart (DE); JACOBI, Martin, 78052 Villingen-Schwenningen (DE)
(86) Internationale Anmeldenummer: PCT/EP2009/054512
(87) Internationale Veröffentlichungsnummer: WO 2009/130156

(56) Entgegenhaltungen:
- EP-A- 1 768 475
- DE-C1- 19 620 430
- US-A- 5 735 697
- US-A1- 2003 017 728
- US-A1- 2007 190 850

## Beschreibung

Die Erfindung betrifft eine Steckverbindung zur Kontaktierung einer in einem Gehäuse angeordneten elektrischen Leiterplatte mit bis außerhalb des Gehäuses geführten Kontakten und mit einer Dichtung zur Abdichtung der Kontakte gegenüber einem Gehäusedurchbruch des Gehäuses.

Solche Steckverbindungen werden häufig bei in heutigen Kraftfahrzeugen eingesetzten Geräten eingesetzt und sind aus der Praxis bekannt. Für die dauerhafte Funktion des Gerätes ist es erforderlich, dass die Dichtheit zuverlässig gewährleistet ist und insbesondere keine Feuchtigkeit durch den Gehäusedurchbruch in das Gerät eindringen kann. Bei den bekannten Steckverbindungen wird meist ein Gummiblock über die Kontakte geschoben. Der Gummiblock dichtet anschließend die Kontakte gegenüber dem Gehäusedurchbruch ab. Nachteilig bei dieser Steckverbindung ist, dass die Fertigung und die Montage des Gummiblocks aufwändig sind. Weiterhin kann der Gummiblock vergessen werden oder verrutschen, so dass die Dichtheit des Gehäuses nicht mehr zuverlässig gewährleistet ist.

Die US 2003/0017728 A1 beschreibt eine Steckverbindung zur Kontaktierung einer in einem Gehäuse angeordneten elektrischen Leiterplatte, wobei die Steckverbindung der Leiterplatte mit einer weiteren Steckverbindung elektrisch und mechanisch verbunden ist, die die Anschlüsse außerhalb eines Gehäuses führt, wobei die zweite Steckverbindung eine Dichtung aufweist, um Eindringen von Fremdstoffen in das Gehäuse zu verhindern.

Die EP 1 768 475 A2 und die US 5,735,697 A beschreiben jeweils eine Steckverbindung mit den Merkmalen des Oberbegriffs des Patentanspruchs 1. Hierbei sind die Dichtungen jeweils in Keilnuten der Steckverbindung angeordnet und liegen ebenfalls an den jeweiligen Gehäusedurchbrüchen an.

Der Erfindung liegt das Problem zugrunde, eine Steckverbindung der eingangs genannten Art so weiter zu bilden, dass sie besonders einfach zu montieren ist und eine zuverlässige Dichtheit des Gehäuses gewährleistet.

Dieses Problem wird erfindungsgemäß durch eine Steckverbindung mit den Merkmalen des Anspruchs 1 gelöst.

Die Fertigung des Trägers und des Dichtrandes gestaltet sich gemäß der Erfindung besonders einfach, da der Träger aus unelastischem Thermoplast und der Dichtrand aus einem elastischen Thermoplast im Spritzgussverfahren gefertigt sind. Für eine gemeinsame Fertigung eines solchen Trägers mit dem Dichtrand wird das Mehrkomponenten-Spritzgießen eingesetzt. Hierdurch sind Träger und Dichtrand einstückig gefertigt und damit gegeneinander zuverlässig abgedichtet. Weiterhin kann der Dichtrand bei der Montage der Steckverbindung nicht verloren gehen, was zur Erhöhung der Zuverlässigkeit der erfindungsgemäßen Steckverbindung gegen ein Eindringen von Feuchtigkeit in das Gehäuse beiträgt.

Die Abdichtung des Trägers gestaltet sich gemäß einer anderen vorteilhaften Weiterbildung der Erfindung konstruktiv besonders einfach, wenn der Gehäusedurchbruch als Schacht ausgebildet ist und wenn der Dichtrand radial außen am Träger angeordnet ist.

Zur weiteren Erhöhung der Dichtheit der erfindungsgemäßen Steckverbindung trägt es bei, wenn der Dichtrand axial auf der der Leiterplatte abgewandten Seite des Trägers angeordnet ist. Der Dichtrand kann dabei gegen das Gehäuse vorgespannt sein und damit die Dichtwirkung des radial am Träger angeordneten Dichtrandes verstärken. Alternativ dazu kann der Dichtrand auch zur Abdichtung eines auf den Kontakten angeordneten Steckers dienen. Vorzugsweise ist der axial auf der der Leiterplatte abgewandten Seite des Trägers angeordnete Dichtrand zusätzlich zu dem radial außen am Träger angeordneten Dichtrand vorgesehen.

Eine Zugentlastung der Kontakte lässt sich gemäß einer anderen vorteilhaften Weiterbildung der Erfindung einfach über das Gehäuse herstellen, wenn der Gehäusedurchbruch einen der Leiterplatte zugewandten Absatz hat und wenn der Träger an dem Absatz anliegt. Durch diese Gestaltung werden Zugkräfte an den Kontakten über den Träger direkt in das Gehäuse eingeleitet. Eine Belastung der Leiterplatte über die Kontakte von außerhalb des Gehäuses wird hierdurch zuverlässig vermieden.

Eine Zugentlastung der Kontakte lässt sich auch bei vorhandenen Gehäusedurchbrüchen ohne Absatz erreichen, wenn der Träger einen an der der Leiterplatte zugewandten Seite des Gehäusedurchbruchs anliegenden Anschlag hat.

Eine einfache Ausrichtung der Kontakte gegenüber der Leiterplatte lässt sich gemäß einer anderen vorteilhaften Weiterbildung der Erfindung einfach erreichen, wenn der Träger einstückig mit in Ausnehmungen der Leiterplatte eindringenden Fixierstiften gefertigt ist. Vorzugsweise sind die Kontakte mit der Leiterplatte verlötet, verpresst oder verpresst und verlötet.

Spannungen zwischen den aus Metall gefertigten Kontakten und dem aus Kunststoff gefertigten Träger können zu Undichtigkeiten führen. Solche Undichtigkeiten lassen sich gemäß einer anderen vorteilhaften Weiterbildung der Erfindung einfach vermeiden, wenn die Kontakte gegenüber dem Träger mittels einer Dichtmasse abgedichtet sind. Weiterhin hat hierdurch der Träger eine Stützfunktion, während die Dichtmasse und der Dichtrand die Abdichtung sicherstellen. Damit ist zudem eine freie Wahl der Materialien des Trägers und der Kontakte gewährleistet.

Eine zuverlässige Verbindung der Kontakte mit dem Träger lässt sich gemäß einer anderen vorteilhaften Weiterbildung der Erfindung einfach erreichen, wenn der Träger rohrförmige, die Kontakte ummantelnde Stutzen aufweist. Die Stutzen ummanteln die Kontakte vorzugsweise einzeln.

Die Erfindung lässt zahlreiche Ausführungsformen zu. Zur weiteren Verdeutlichung ihres Grundprinzips ist eine davon in der Zeichnung dargestellt und wird nachfolgend beschrieben. Diese zeigt in
- Fig. 1: eine Schnittdarstellung durch eine erfindungsgemäße Steckverbindung,
- Fig. 2: eine Seitenansicht eines Trägers mit Kontakten der Steckverbindung aus Figur 1,
- Fig. 3: eine weitere Ausführungsform der erfindungsgemäßen Steckverbindung mit einem Absatz in einem Gehäusedurchbruch,
- Fig. 4: eine weitere Ausführungsform der erfindungsgemäßen Steckverbindung mit einem Anschlag am Träger.

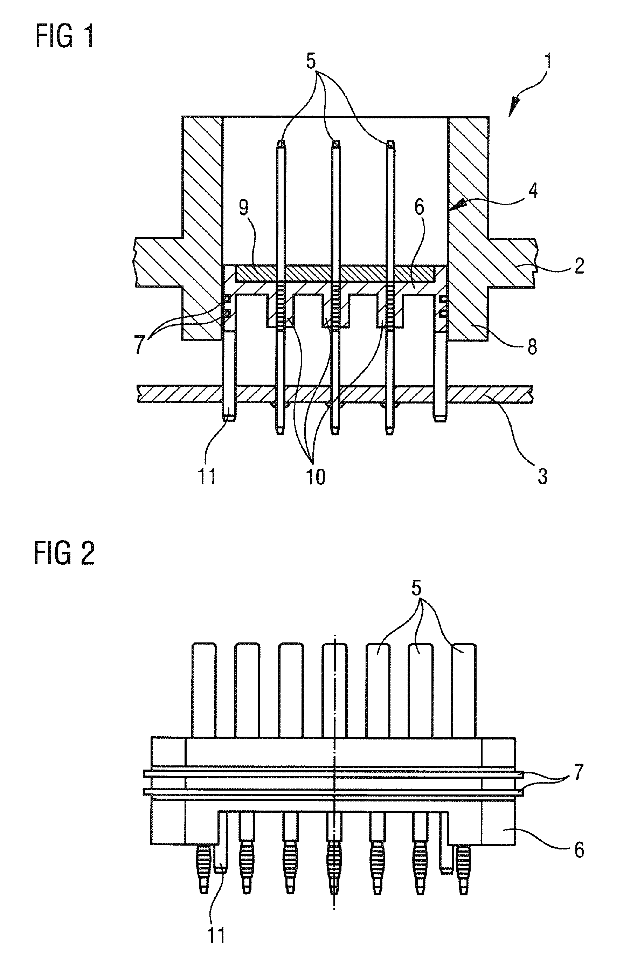

Figur 1 zeigt eine Schnittdarstellung durch eine Steckverbindung 1 eines elektrischen Gerätes mit einer in einem Gehäuse 2 angeordneten Leiterplatte 3 und mit durch einen Gehäusedurchbruch 4 geführten Kontakten 5. Jeweils ein Ende der Kontakte 5 ist in der Leiterplatte 3 verlötet, verpresst oder verpresst und verlötet, während das andere Ende aus dem Gehäuse 2 herausragt. Auf dem aus dem Gehäuse 2 herausragenden Ende der Kontakte 5 lässt sich ein nicht dargestellter Stecker aufstecken.

Die Kontakte 5 sind untrennbar, beispielsweise durch Einpressen oder Umgießen im Spritzgussverfahren mit einem gemeinsamen Träger 6 verbunden. Der Träger 6 hat radial außen umlaufende Dichtränder 7. Die Dichtränder 7 dichten den Träger 6 gegenüber einem Schacht 8 des Gehäusedurchbruchs 4 ab. Eine Dichtmasse 9 dichtet die Kontakte 5 untereinander und gegenüber dem Träger 6 ab. Der Träger 6 weist zudem rohrförmige, die Kontakte 5 einzeln ummantelnde Stutzen 10 auf.

Weiterhin hat der Träger 6 in die Leiterplatte 3 eindringende Fixierstifte 11. Diese Fixierstifte 11 dienen bei der Montage vor der Verlötung der Kontakte 5 an der Leiterplatte 3 zur Ausrichtung des Trägers 6. Nach der Verlötung wird die Leiterplatte 3 in das Gehäuse 2 eingesetzt und der Träger 6 und die Kontakte 5 in den Gehäusedurchbruch 4 eingeführt. Dabei dichten die Dichtränder 7 des Trägers 6 das Gehäuse 2 ab.

Wie Figur 2 in einer Seitenansicht auf den Träger 6 mit den Kontakten 5 vor der Montage zeigt, sind die Dichtränder 7 an dem Träger 6 angeordnet, vorzugsweise durch Mehrkomponenten-Spritzgießen gefertigt.

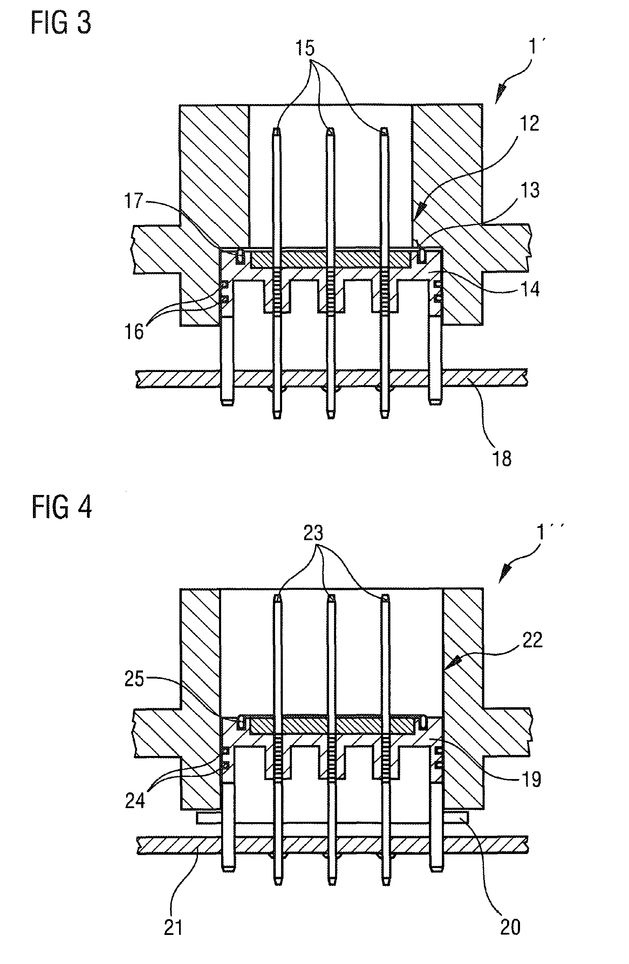

Figur 3 zeigt eine weitere Ausführungsform der Steckverbindung 1' welche sich von der aus Figur 1 dadurch unterscheidet, dass in einem Gehäusedurchbruch 12 ein Absatz 13 angeordnet ist. Ein Träger 14 mit Kontakten 15 steht dem Absatz 13 gegenüber. Weiterhin hat der Träger 14 zwei radial umlaufende Dichtränder 16 und zusätzlich einen axial von einer Leiterplatte 18 weg weisenden Dichtrand 17. Der axial von der Leiterplatte 18 weg weisende Dichtrand 17 liegt an dem Absatz 13 im Gehäusedurchbruch 12 an. Ansonsten ist diese Ausführungsform der Steckverbindung 1' wie die aus den Figuren 1 und 2 aufgebaut.

Figur 4 zeigt eine weitere Ausführungsform der Steckverbindung 1", welche sich von der aus Figur 1 dadurch unterscheidet, dass ein Träger 19 einstückig mit einem radial abstehenden Anschlag 20 gefertigt ist. Der Anschlag 20 ist auf der einer Leiterplatte 21 zugewandten Seite eines Gehäusedurchbruchs 22 angeordnet. Weiterhin hat der Träger 19 mehrere Kontakte 23, zwei radial umlaufende Dichtränder 24 zur Abdichtung gegenüber dem Gehäusedurchbruch 22 und einen axial von der Leiterplatte 21 weg abstehenden Dichtrand 25. Dieser axial abstehende Dichtrand 25 dient zur Abdichtung des Trägers 19 gegenüber einem nicht dargestellten, auf den Kontakten 23 aufgesteckten Stecker.

## Patentansprüche

1. Steckverbindung zur Kontaktierung einer in einem Gehäuse angeordneten elektrischen Leiterplatte mit bis außerhalb des Gehäuses geführten Kontakten und mit einer Dichtung zur Abdichtung der Kontakte gegenüber einem Gehäusedurchbruch des Gehäuses, wobei die Kontakte (5, 15, 23) untrennbar mit einem Träger (6, 14, 19) verbunden sind, der Träger (6, 14, 19) zumindest einen umlaufenden Dichtrand (7, 16, 17, 24, 25) aufweist und der Dichtrand (7, 16, 17, 24, 25) an dem Gehäusedurchbruch (4, 12, 22) anliegt, **dadurch gekennzeichnet dass** der Träger (6, 14, 19) aus unelastischem Thermoplast und der Dichtrand (7, 16, 17, 24, 25) aus einem elastischen Thermoplast im Mehrkomponenten-Spritzgussverfahren gefertigt sind.

2. Steckverbindung nach Anspruch 1, **dadurch gekennzeichnet, dass** der Gehäusedurchbruch (4, 12, 22) als Schacht (8) ausgebildet ist und dass der Dichtrand (7, 16, 24) radial außen am Träger (6, 14, 19) angeordnet ist.

3. Steckverbindung nach einem der vorhergehenden Ansprüche, **dadurch gekennzeichnet, dass** der Dichtrand (17, 25) axial auf der der Leiterplatte abgewandten Seite des Trägers (14, 19) angeordnet ist.

4. Steckverbindung nach einem der vorhergehenden Ansprüche, **dadurch gekennzeichnet, dass** der Gehäusedurchbruch (12) einen der Leiterplatte (18) zugewandten Absatz (13) hat und dass der Träger (14) an dem Absatz (13) anliegt.

5. Steckverbindung nach einem der vorhergehenden Ansprüche, **dadurch gekennzeichnet, dass** der Träger (19) einen an der der Leiterplatte (21) zugewandten Seite des Gehäusedurchbruchs (22) anliegenden Anschlag (20) hat.

6. Steckverbindung nach einem der vorhergehenden Ansprüche, **dadurch gekennzeichnet, dass** der Träger (6, 14, 19) einstückig mit in Ausnehmungen der Leiterplatte eindringenden Fixierstiften (11) gefertigt ist.

7. Steckverbindung nach einem der vorhergehenden Ansprüche, **dadurch gekennzeichnet, dass** die Kontakte (5, 15, 23) gegenüber dem Träger (6, 14, 19) mittels einer Dichtmasse abgedichtet sind.

8. Steckverbindung nach einem der vorhergehenden Ansprüche, **dadurch gekennzeichnet, dass** der Träger (6, 14, 19) rohrförmige, die Kontakte (5, 15, 23) ummantelnde Stutzen (10) aufweist.

## Claims

1. Plug-type connection for making contact with an electrical printed circuit board which is arranged in a housing, having contacts which are routed to outside the housing and having a seal for sealing off the contacts from an aperture in the housing, the contacts (5, 15, 23) being inseparably connected to a support (6, 14, 19), the support (6, 14, 19) having at least one peripheral sealing edge (7, 16, 17, 24, 25), and the sealing edge (7, 16, 17, 24, 25) bearing against the housing aperture (4, 12, 22), **characterized in that** the support (6, 14, 19) is produced from an inelastic thermoplastic and the sealing edge (7, 16, 17, 24, 25) is produced from an elastic thermoplastic using the multi-component injection molding method.

2. Plug-type connection according to Claim 1, **characterized in that** the housing aperture (4, 12, 22) is in the form of a shaft (8), and **in that** the sealing edge (7, 16, 24) is arranged radially on the outside of the support (6, 14, 19).

3. Plug-type connection according to one of the preceding claims, **characterized in that** the sealing edge (17, 25) is arranged axially on that side of the support (14, 19) which is averted from the printed circuit board.

4. Plug-type connection according to one of the preceding claims, **characterized in that** the housing aperture (12) has a projection (13) which faces the printed circuit board (18), and **in that** the support (14) bears against the projection (13).

5. Plug-type connection according to one of the preceding claims, **characterized in that** the support (19) has a stop (20) which bears against that side of the housing aperture (22) which faces the printed circuit board (21).

6. Plug-type connection according to one of the preceding claims, **characterized in that** the support (6, 14, 19) is integrally produced with fixing pins (11) which enter recesses in the printed circuit board.

7. Plug-type connection according to one of the preceding claims, **characterized in that** the contacts (5, 15, 23) are sealed off from the support (6, 14, 19) by means of a sealing compound.

8. Plug-type connection according to one of the preceding claims, **characterized in that** the support (6, 14, 19) has tubular stubs (10) which sheath the contacts (5, 15, 23).

## Revendications

1. Connecteur à fiches pour la mise en contact d'une plaquette à circuits imprimés électrique, disposée dans un boîtier, ayant des contacts guidés jusqu'à l'extérieur du boîtier et ayant une étanchéité pour rendre étanche les contacts vis-à-vis d'une traversée du boîtier, les contacts (5, 15, 23) étant reliés de manière inséparable à un support (6, 14, 19), le support (6, 14, 19) ayant au moins un bord (7, 16, 17, 24, 25) d'étanchéité de pourtour et le bord (7, 16, 17, 24, 25) d'étanchéité s'appliquant à la traversée (4, 12, 22) du boîtier, **caractérisé en ce que** le support (6, 14, 19) en une matière thermoplastique inélastique et le bord (7, 16, 17, 24, 25) d'étanchéité en une matière thermoplastique élastique sont fabriqués par le procédé de moulage par injection à plusieurs composants.

2. Connecteur à fiches suivant la revendication 1, **caractérisé en ce que** la traversée (4, 12, 22) du boîtier est constituée en puits (8) et **en ce que** le bord (7, 16, 24) d'étanchéité est disposé à l'extérieur radialement sur le support (6, 14, 19).

3. Connecteur à fiches suivant l'une des revendications précédentes, **caractérisé en ce que** le bord (17, 25) d'étanchéité est disposé axialement du côté du support (14, 19) éloigné de la plaquette à circuit imprimé.

4. Connecteur à fiches suivant l'une des revendications précédentes, **caractérisé en ce que** la traversée (12) du boîtier a un ressaut (13) tourné vers la plaquette (18) à circuits imprimés et **en ce que** le support (14) s'applique au ressaut (13).

5. Connecteur à fiches suivant l'une des revendications précédentes, **caractérisé en ce que** le support (19) a une butée (20) s'appliquant du côté de la traversée (22) du boîtier, tourné vers la plaquette (21) à circuits imprimés.

6. Connecteur à fiches suivant l'une des revendications précédentes, **caractérisé en ce que** le support (6, 14, 19) est fabriqué d'une seule pièce avec des broches (11) d'immobilisation pénétrant dans des évidements de la plaquette à circuits imprimés.

7. Connecteur à fiches suivant l'une des revendications précédentes, **caractérisé en ce que** les contacts (5, 15, 23) sont rendus étanches vis-à-vis du support (6, 14, 19) au moyen d'une composition d'étanchéité.

8. Connecteur à fiches suivant l'une des revendications précédentes, **caractérisé en ce que** le support (6, 14, 19) comporte des raccords (10) tubulaires gainant les contacts (5, 15, 23).
